# EUROPEAN PATENT APPLICATION

(11) **EP 4 753 399 A1**
(43) Date of publication of application: **03.06.2026**
(21) Application number: 24215684.2
(22) Date of filing: 27.11.2024
(51) Int. Cl.: H10D 30/01, H10D 30/62

(54) **A METHOD FOR PRODUCING A SEMICONDUCTOR STRUCTURE**

(71) Applicant: Imec VZW, 3001 Leuven (BE)
(72) Inventor: GANGULY, Jishnu, 3000 Leuven (BE); HORIGUCHI, Naoto, 3000 Leuven (BE); BASTOS, Joao, 3010 Kessel-Lo (BE)
(74) Representative: AWA Sweden AB

(57) **Abstract**

A method for producing a semiconductor structure (100) is provided. The method comprises: providing (12) a semiconductor fin (110) on a substrate (102), the semiconductor fin (110) comprising a first side surface (111), a second side surface (112) opposing the first side surface (111), and a top surface (113), wherein a mask (120) covers the top surface (113) of the semiconductor fin (110); exposing (14) a portion (114) of the top surface (113) of the semiconductor fin (110) by removing (15) a portion (124) of the mask (120), the exposed portion (114) of the top surface (113) and the first side surface (111) forming an exposed top corner (130) of the semiconductor fin (110); rounding (16) the exposed top corner (130) of the semiconductor fin (110) by oxidizing (17) the exposed portion (114) of the top surface (113) and the first side surface (111).

## Description

### TECHNICAL FIELD

The present inventive concept relates, in general, to a method for producing a semiconductor structure.

### BACKGROUND

Modern semiconductor integrated circuit technology includes various types of field-effect transistors (FETs). A FET generally comprises at least one channel extending horizontally between a source and a drain, the at least one channel comprising a semiconductor. Further, the FET generally comprises a gate for controlling a current through the at least one channel.

One notable example of a FET is the FinFET. In the FinFET, a semiconductor fin forms the channel of the transistor, and the gate typically straddles the Fin.

### SUMMARY

It is an objective of the present inventive concept to enable a FinFET suitable for high-voltage applications, such a FinFET may be called a high-voltage FinFET (HV FinFET). High-voltage applications may be e.g. applications where the FinFET need to endure voltages to the gate and source-drain terminals which are higher, e.g. much higher, than for a core logic FET. An example of a high-voltage application is a FinFET of a 3D-NAND memory system, e.g. a FinFET for cell program and/or cell erase in the 3D-NAND memory system, e.g. a wordline FinFET for cell program and/or cell erase in the 3D-NAND memory system. Thus, it is an objective to enable a 3D-NAND memory system.

It is a realization that high-voltage FET design needs careful optimization to enable a transition from planar FETs to FinFETs. Typically, the semiconductor fin of a high-voltage FinFET will support a thick gate-oxide to endure strong electric fields owing to the high voltages from gate and source-drain terminals.

It is a further objective of the present inventive concept to enable a high-quality HV FinFET. It is a further objective to enable a high-quality 3D-NAND memory system.

It is a further objective of the present inventive concept to facilitate easy and/or low-cost manufacturing of the HV FinFET. It is a further objective to facilitate easy and/or low-cost manufacturing of the 3D-NAND memory system.

These and other objectives of the inventive concept are at least partly met by the invention as defined in the independent claims. Preferred embodiments are set out in the dependent claims.

In the following, relative spatial terms such as "top", "bottom", "lower", and "vertical" are to be understood as denoting locations or directions within a frame of reference of the semiconductor structure. In particular, the terms may be understood in relation to a normal direction to a substrate on which a fin of the semiconductor structure is formed. Correspondingly, terms such as "lateral" and "horizontal" are to be understood as locations or directions parallel to the substrate.

A first direction may be understood as a direction in which the current flows in the finished transistor. A second direction may be understood as a direction transverse to the first direction. A third direction may be understood as the vertical or bottom-up direction. The first and second directions may be parallel to the substrate. The third direction may be normal to the substrate.

According to a first aspect, there is provided a method for producing a semiconductor structure, the method comprising:
providing a semiconductor fin on a substrate, the semiconductor fin comprising a first side surface, a second side surface opposing the first side surface, and a top surface, wherein a mask covers the top surface of the semiconductor fin;
exposing a portion of the top surface of the semiconductor fin by removing a portion of the mask, the exposed portion of the top surface and the first side surface forming an exposed top corner of the semiconductor fin;
rounding the exposed top corner of the semiconductor fin by oxidizing the exposed portion of the top surface and the first side surface.

The semiconductor fin may be formed by etching out the semiconductor fin from the substrate or etching out the semiconductor fin from a layer deposited on the substrate, e.g. etching out the semiconductor fin from a layer epitaxially grown on the substrate. The semiconductor fin may for example comprise silicon, germanium, or silicon germanium, but is not limited thereto and may comprise any semiconductor material. The substrate may comprise for example silicon, germanium, or silicon germanium, but is not limited thereto and may comprise any semiconductor material.

The semiconductor fin may extend in the first direction. The side surfaces may be normal to the second direction. The semiconductor fin may comprise two opposing end surfaces. The end surfaces may be normal to the first direction.

The mask covering the top surface of the semiconductor fin implies that the mask extends over an entire area of the top surface. The mask covering the top surface of the fin may have been deposited on the substrate prior to etching out the semiconductor fin and may have been used as an etch mask for etching out the semiconductor fin. Alternatively, the mask may be provided on the top surface of the semiconductor fin after etching out the semiconductor fin. The mask may be a hardmask. The mask may comprise for example silicon nitride, silicon oxycarbide, or any silicon oxycarbonitride composite, but is not limited thereto and may comprise any semiconductor material.

When exposing a portion of the top surface of the semiconductor fin by removing a portion of the mask, the portion of the mask may be removed by etching, as will be discussed below. The exposed top corner of the semiconductor fin may be the corner at the intersection between the first side surface and the top surface, this may be called the left top corner. The exposed top corner of the semiconductor fin may be the corner at the intersection between the second side surface and the top surface, this may be called the right top corner. Advantageously, both the left and right top corners may be exposed and then rounded.

The semiconductor fin having a rounded top corner according to the method may be used to produce a FinFET, e.g. a HV FinFET. A FinFET may be produced by forming a gate straddling the semiconductor fin and forming source/drain (S/D) regions on opposite end surfaces of the semiconductor fin.

Such a FinFET may be used to produce a 3D-NAND memory system, e.g. by incorporating the FinFET as a wordline transistor in the 3D-NAND memory system.

It is a realization that the rounded top corner may reduce a build up of electric field strength in the vicinity of the top corner in the finished FinFET, as compared to a less rounded top corner. When a voltage is applied to the semiconductor fin, sharp corners may locally accentuate the field strength of the electric field. Thus, by rounding the top corner, the electric field strength in the vicinity of the top corner may be reduced.

The reduced electric field strength at the rounded top corner implies that electrical stress that may be exerted on for example a gate-oxide that at least partially covers the semiconductor fin may be reduced. In other words, given a certain voltage applied to the semiconductor fin, the chance for breakdown of the gate-oxide may be reduced according to the method.

The reduced stress exerted on the gate-oxide as a result of rounding the top corner implies for example that a higher voltage could be applied to the semiconductor fin and/or that a thinner gate-oxide could be used, without causing a breakdown of the gate-oxide.

It is a realization that covering the top surface with the mask and removing a portion of the mask to form an exposed top corner allows for a high degree of control in the rounding of the corner. The amount of rounding may be controlled by removing a smaller or larger portion of the mask such that the exposed portion of the top surface is smaller or larger respectively.

The semiconductor fin may have a width of at least 6 nm. For example the semiconductor fin may have a width in a range of 6-100 nm. The semiconductor fin may have a length of at least 20 nm, preferably at least 100 nm, more preferably at least 500 nm. These lengths may be suitable for high-voltage applications.

A height of the semiconductor fin may be defined as the shortest distance in the third direction from the substrate to the top surface of the semiconductor fin. The semiconductor fin may have a height of at least 10 nm. For example, the semiconductor fin may have a height in a range of 10-120 nm. More preferable, the semiconductor fin may have a height of at least 40 nm, for example in a range of 40-120 nm.

The S/D regions may be formed during the manufacturing of the FinFET. For example, the end surfaces of the fin may be exposed by source/drain recessing. The S/D regions may then be formed on the exposed end surfaces. The S/D regions may be formed by epitaxial growth.

The exposed portion of the top surface may comprise an exposed left portion of the top surface. The exposed left portion of the top surface and the first side surface may form the exposed top corner of the semiconductor fin, this may be called the exposed left top corner. Thus, the exposed left portion of the top surface may be a portion of the top surface extending from the intersection between the first side surface and the top surface of the fin towards a central axis of the top surface. Also or alternatively, the exposed portion of the top surface may comprise an exposed right portion of the top surface. The exposed right portion of the top surface and the second side surface may form the exposed top corner of the semiconductor fin, this may be called the exposed right top corner. Thus, the exposed right portion of the top surface may be a portion of the top surface extending from the intersection between the second side surface and the top surface of the fin towards a central axis of the top surface.

It is to be understood that any processes herein described as relating to the exposed top corner may by analogy refer to either the exposed left top corner, the exposed right top corner, or both. The semiconductor fin may comprise any of or both of the exposed left top corner and the exposed right top corner Further, the semiconductor fin may comprise any arbitrary number of additional exposed top corners, which may be referred to as exposed top corners.

Rounding the exposed top corner of the semiconductor fin implies that an effective radius of curvature of the top corner increases.

Rounding may for example imply that a radius of curvature is in a range of 1 to 40 nm, preferably in a range of 1 to 20 nm, more preferably in a range of 1 to 10 nm.

Rounding by oxidizing implies that the exposed portion of the top surface and the first side surface are subject to an oxidation process. A covered portion of the top surface, which is covered by the mask, is shielded from the oxidation process such that it at least oxidizes less than the exposed portion of the top surface and the first side surface. Thus, material of the semiconductor fin is oxidized in the vicinity of the exposed top corner such that the exposed top corner is rounded. The height of the semiconductor fin may be unchanged by the rounding of the top corner.

A width of the exposed portion of the top surface of the semiconductor fin may be at least 5% of the width of the fin. Alternatively, the width of the exposed portion of the top surface of the semiconductor fin may be at least 10% of the width of the fin. A larger exposed portion of the top surface of the semiconductor fin may result in more rounding of the top corner, i.e. a larger effective radius of curvature of the exposed top corner.

The step of removing the portion of the mask may comprise laterally etching at least part of the mask. Lateral etching implies that a material of the mask is etched from the side towards a central axis of the mask, resulting in a reduced width of the mask. The mask may be etched in the second direction, i.e. parallel to the substrate and perpendicular to the first direction in which the fin extends. Laterally etching the mask enables a high degree of control of the width of the exposed portion of the top surface, and thus of the dimensions and shape of the exposed top corner and the rounding of the exposed top corner.

Alternatively, the step of removing the portion of the mask may comprise using lithography, with or without a lithography mask, combined with etching. If using lithography, the etching may be performed laterally or top-down (vertically).

The step of laterally etching the mask may comprise wet etching. As an example, the step of laterally etching the mask may comprise wet etching by a mixture of Hydrofluoric acid (HF) and Phosphoric acid (H₃PO₄). As an alternative example, the step of laterally etching the mask may comprise wet etching by a sulfuric peroxide mix (SPM). A sulfuric peroxide mix may be a mixture of sulfuric acid (H₂SO₄) and hydrogen peroxide (H₂O₂). Wet etching is advantageous for lateral etching because it etches isotropically and reduces damage on the structure, compared to for example dry etching.

In some embodiments, the mask may comprise a first layer and a second layer, the first layer being arranged between the top surface of the semiconductor fin and the second layer,
wherein removing the portion of the mask may comprise
removing a first portion of the first layer of the mask; and
removing a first portion of the second layer of the mask;
wherein the first portion of the second layer of the mask is a portion above the first portion of the first layer of the mask.

In other words, by analogy with previous description, the removed first portion of the first layer and the first side surface may form the exposed top corner, this may be called the exposed left top corner. Also or alternatively, a removed second portion of the first layer and the second side surface may form the exposed top corner, this may be called the exposed right top corner.

The first layer and the second layer of the mask may comprise different material compositions. The first layer and the second layer of the mask may have different thicknesses. The first layer may comprise for example silicon oxide. The second layer may comprise for example silicon nitride, silicon oxycarbonitride, or titanium nitride. A metarial of the first layer and a material of the second layer may be etch selective compared to each other, so that one can be etched without etching the other. Using silicon oxide for the second layer is advantageous because silicon oxide is durable under physical stress. A width of the removed first portion of the first layer may differ from a width of the removed first portion of the second layer.

By using a mask with two layers, control may be further improved for the step of removing a portion of the mask and the step of rounding the exposed top corner. Control may be improved for example by controlling the width of the removed first portion of the first layer compared to the width of the removed first portion of the second layer. Further, for example, the material of the first layer may be chosen to reduce the strain induced on the fin.

The width of the removed first portion of the second layer of the mask may be larger than the width of the removed first portion of the first layer of the mask. Alternatively, the width of the removed first portion of the second layer of the mask may be smaller than the width of the removed first portion of the first layer of the mask.

By controlling the width of the removed first portion of the second layer and the width of the removed first portion of the first layer, and the relationship between said widths, control may be further improved for the step of removing a portion of the mask and the step of rounding the exposed top corner.

The step of removing the first portion of the first layer of the mask may be performed in a first etch process; and removing the first portion of the second layer of the mask may be performed in a second etch process, the second etch process may be subsequent to the first etch process.

Thus, different etchants and different etch processes may be used for the first layer and the second layer of the mask, so that the etch of the respective layers can be controlled independently of each other.

The step of oxidizing the exposed portion of the top surface and the first side surface may be performed by wet oxidation. Wet oxidation may facilitate forming an oxide with improved quality and an improved oxidation integrity. Alternative methods of oxidation comprise for example oxidation in a wet atmosphere with Chlorine (Cl) or dry oxidation. Note that any form of oxidation process is expected to bring the benefits related to the step of rounding the exposed top corner by oxidizing the exposed top corner.

Wet oxidation may comprise an in-situ steam generation, ISSG, process.

It is a realization that the ISSG process effectively rounds the exposed top corner. It is a realization that the ISSG process forms a suitable curvature of the rounded top corner.

The ISSG process is a wet oxidation process. The ISSG process may comprise forming steam in the process chamber. In particular, the ISSG process may comprise forming steam in close proximity to the substrate surface (and thereby also in close proximity to the semiconductor fin). The ISSG process may be seen to differ from conventional furnace wet oxidation. In conventional furnace wet oxidation, steam is generated outside the process chamber.

The ISSG process may be performed in a rapid thermal processing chamber.

The method may further comprise conformally coating the semiconductor fin with a gate oxide layer. The gate oxide layer may electrically insulate the semiconductor fin for example from a gate that may be formed to straddle the semiconductor fin. The gate oxide may for example comprise silicon dioxide, silicon oxynitride, hafnium dioxide, or hafnium zirconium dioxide, but is not limited thereto. Conformally coating may comprise for example oxide growth and/or atomic layer deposition (ALD).

The method may further comprise removing oxide formed during the step of oxidizing the exposed portion of the top surface and the first side surface, wherein removing said oxide is performed before the step of conformally coating the semiconductor fin with the gate oxide layer.

Also or alternatively, the mask may be removed before the step of conformally coating the semiconductor fin with the gate oxide layer.

By removing the oxide formed during the step of oxidizing the exposed portion of the top surface and the first side surface and/or the mask it may be ensured that said oxide and/or mask does not form part of the gate oxide of the finished transistor. Thus, said oxide and/or mask may be replaced by another gate oxide which may have better electrical properties.

The gate oxide layer may have a thickness of at least 10 nm, preferably at least 20 nm, more preferably at least 40 nm. These thicknesses may be more suitable for high-voltage applications.

The method may further comprise:
forming a 3D-NAND memory system on the substrate; and
forming a wordline transistor on the substrate, wherein a channel region of the wordline transistor comprises the semiconductor fin.

A 3D-NAND memory system comprises a plurality of memory cells arranged in a 3D matrix. Each memory cell may comprise a control gate for reading and/or writing and/or erasing data from the memory cell.

A wordline may extend along a row of memory cells of the 3D-NAND memory system. The wordline may be electrically connected to the control gate of the memory cells of the row. Thus, a voltage of the wordline may control the memory cells of the row. The wordline transistor may be connected to the wordline. The wordline transistor may be configured to apply the voltage to the wordline. In other words, the wordline transistor may select which row of memory cells is accessed during operation of the 3D-NAND memory system.

The 3D-NAND system and the wordline transistor according may have the same advantages, or similar advantages, as the advantages described in conjunction with the method.

### BRIEF DESCRIPTION OF THE DRAWINGS

The above, as well as additional objects, features and advantages of the present inventive concept, will be better understood through the following illustrative and non-limiting detailed description, with reference to the appended drawings. In the drawings like reference numerals will be used for like elements unless stated otherwise.
Fig. 1 illustrates a flowchart of a method for producing a semiconductor structure
Fig. 2 illustrates a cross-sectional view of a semiconductor structure according to an embodiment.
Fig. 3 illustrates a cross-sectional view of a semiconductor structure according to various embodiments.
Fig. 4 illustrates a cross-sectional view of a semiconductor structure according to an embodiment.

### DETAILED DESCRIPTION

In cooperation with attached drawings, the technical contents and detailed description of the present invention are described thereinafter according to a preferable embodiment, being not used to limit the claimed scope. This invention may be embodied in many different forms and should not be construed as limited to the embodiments set forth herein; rather, these embodiments are provided for thoroughness and completeness, and fully convey the scope of the invention to the skilled person.

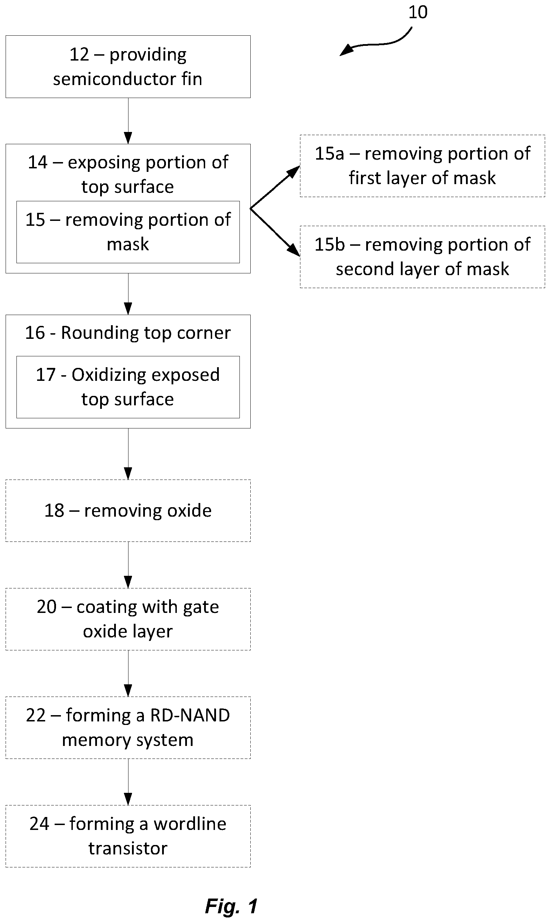

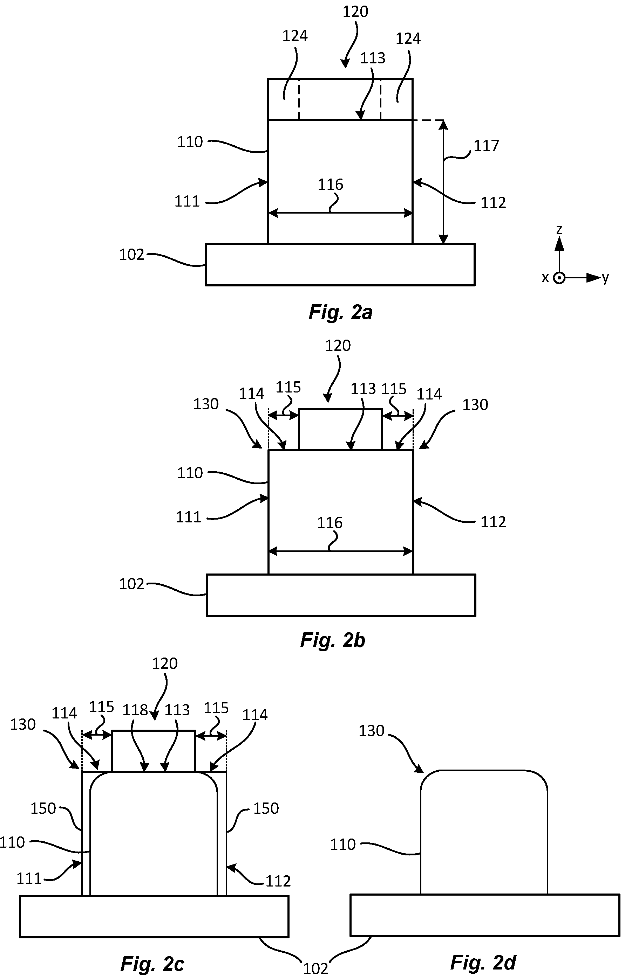

Referring to Fig. 1 in conjunction with Figs 2a-2d, a method 10 for producing a semiconductor structure 100 will be described. The method 10 will be described as comprising a number of steps. However, it should be realized that some of these steps are optional and may not necessarily be performed or may be performed in various different ways. Thus, the detailed description of the method provided herein should not be construed as limiting the scope of the description.

The method 10 comprises providing 12 a semiconductor fin 110 on a substrate 102. The providing 101 of the semiconductor fin 110 may refer to obtaining the semiconductor fin 110 or may refer to performing any number of processing steps required to produce the semiconductor fin 110. For example, the semiconductor fin 110 may be formed by etching out the semiconductor fin 110 from the substrate 102 or etching out the semiconductor fin 110 from a layer deposited on the substrate 102, e.g. etching out the semiconductor fin 110 from a layer epitaxially grown on the substrate 102.

Fig. 2a illustrates the semiconductor fin 110 with the mask 120 covering the top surface 113. Figs. 2a-2d all have the same orientation. Portions of the mask 124 that will later be removed (see below) are marked in the figure. The semiconductor fin 110 comprises a first side surface 111, a second side surface 112 opposing the first side surface 111, and a top surface 113. The semiconductor fin may extend in a first direction (x). The side surfaces may be normal to a second direction (y). The semiconductor fin 110 may comprise two opposing end surfaces. The end surfaces may be normal to the first direction (x).

The semiconductor fin 110 may comprise for example silicon, germanium, or silicon germanium. The substrate 102 may comprise for example silicon, germanium, or silicon germanium.

The semiconductor fin 110 may have a length, extending in the first direction (x), of at least 20 nm, preferably at least 100 nm, more preferably at least 500 nm. The semiconductor fin 110 may have a width 116, extending in the second direction (y), of at least 6 nm. For example the semiconductor fin may have a width in a range of 6-100 nm. A height 117 of the semiconductor fin 110 may be defined as the shortest distance in a third direction (z) from the substrate 102 to the top surface 113 of the semiconductor fin 110. The semiconductor fin may have a height 117 of at least 10 nm. For example, the semiconductor fin may have a height in a range of 10-120 nm. More preferable, the semiconductor fin may have a height of at least 40 nm, for example in a range of 40-120 nm.

A mask 120 covers the top surface 113 of the semiconductor fin 110. In other words, the semiconductor fin 110 is arranged between the substrate 102 and the mask 120. The mask covering the top surface of the fin may have been deposited on the substrate prior to etching out the semiconductor fin and may have been used as an etch mask for etching out the semiconductor fin. Alternatively, the mask may be provided on the top surface of the semiconductor fin after etching out the semiconductor fin.

As discussed above, the method 10 comprises exposing 14 a portion 114 of the top surface 113 of the semiconductor fin 110 by removing 15 a portion 124 of the mask 120. The exposed portion 114 of the top surface 113 and the first side surface 111 forming an exposed top corner 130 of the semiconductor fin 110. Also or alternatively, an exposed top corner 130 of the semiconductor fin may be formed by the exposed portion 114 of the top surface 113 and the second side surface 112.

Fig. 2b illustrates the semiconductor fin 110 after removal of portions 124 of the mask 120. In the figure, two portions 124 of the mask 120 have been removed, exposing a left top corner as well as a right top corner.

According to the method, one or several portions 124 of the mask may be removed.

In the figure, one exposed top corner 130 of the semiconductor fin 110 is the corner at the intersection between the first side surface 111 and the top surface 113, this exposed top corner 130 may be called the left top corner. In this case, the exposed portion 114 of the top surface 113 is a portion of the top surface 113 extending from the intersection between the first side surface 111 and the top surface 113 of the semiconductor fin 110 towards a central axis of the top surface 113.

In the figure, another exposed top corner 130 of the semiconductor fin 110 is the corner at the intersection between the second side surface 112 and the top surface 113, this exposed top corner 130 may be called the right top corner. In this case, the exposed portion 114 of the top surface 113 is a portion of the top surface 113 extending from the intersection between the second side surface 112 and the top surface 113 of the semiconductor fin 110 towards a central axis of the top surface 113.

In accordance with the above, the exposed top corner 130 may refer to any one of or both of the left top corner and the right top corner.

A width 115 of the exposed top portion 114, extending in the first direction (x), may be at least 5% of the width 116 of the semiconductor fin 110, preferably at least 10% of the width 116 of the semiconductor fin 110.

Exposing 14 a portion 114 of the top surface 113 of the semiconductor fin 110 by removing 15 a portion 124 of the mask 120 may comprise laterally etching at least part of the mask 120. Lateral etching implies that a material of the mask 120 is etched from the first side 111 and/or the second side 112 towards a central axis of the mask 120, resulting in a reduced width of the mask 120. In other words, the etch progresses in the first direction (x), parallel to the substrate.

The step of laterally etching the mask 120 may comprise wet etching. Wet etching may comprise for example a combination of Hydrofluoric acid (HF) and Phosphoric acid (H₃PO₄).

As discussed above, the method 10 comprises rounding 16 the exposed top corner 130 of the semiconductor fin 110 by oxidizing 17 the exposed portion 114 of the top surface 113 and the first side surface 111. Rounding the exposed top corner 130 of the semiconductor fin 110 implies that an effective radius of curvature of the exposed top corner 130 increases.

Fig. 2c illustrates the semiconductor fin 110 after rounding the exposed corners.

Rounding 16 by oxidizing 17 implies that the exposed portion 114 of the top surface 113 and the first side surface 111 are subject to an oxidation process. Also or alternatively, the exposed portion 114 of the top surface 113 and the second side surface 112 are subject to an oxidation process. The step of oxidizing 17 results in the formation of an oxidized portion 150, the oxidized portion 150 comprising oxidized material that was material of the semiconductor fin 110 prior to the step of oxidizing 17.

A covered portion 118 of the top surface 113, which is covered by the mask 120, is shielded from the oxidation process such that it at least oxidizes less than the exposed portion 114 of the top surface and the first side surface 111 and/or the second side surface 112.

The step of oxidizing the exposed portion 114 of the top surface 113 and the first side surface 111 may be performed by wet oxidation. Wet oxidation may comprise an in-situ steam generation, ISSG, process.

The oxide formed during the step of oxidizing the exposed top corner may subsequently be removed. It may e.g. be advantageous to remove said oxide before depositing the gate oxide. Thus, the step of oxidizing the exposed top corner may be optimized for rounding while the deposition of gate oxide may be optimized to give good electrical properties of the gate oxide.

Alternatively, the oxide formed during the step of oxidizing the exposed top corner may be retained. The oxide formed during the step of oxidizing the exposed top corner may e.g. be integrated in the gate oxide.

Fig. 2d shows the semiconductor fin 110 with a rounded top corner after removal of the oxide formed during the step of oxidizing the exposed top corner. The semiconductor fin 110 having the rounded top corner according to the method may be used to produce a FinFET, e.g. a HV FinFET. A FinFET may be produced by forming a gate straddling the semiconductor fin 110 and forming source/drain (S/D) regions on the end surfaces of the semiconductor fin 110.

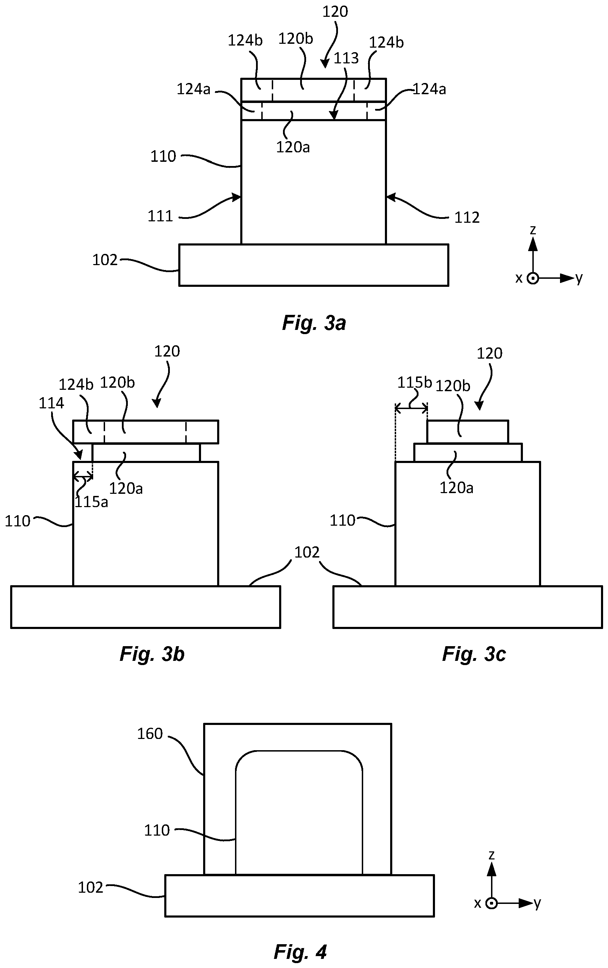

Referring to Fig. 3a-3c, in some embodiments, the mask 120 may comprise a first layer 120a and a second layer 120b, the first layer 120a being arranged between the top surface 113 of the semiconductor fin 110 and the second layer 120b. Figs. 3a-3c all have the same orientation.

The step of removing 15 the portion 124 of the mask 120 may in an optional step comprise removing 15a a first portion 124a of the first layer 120a of the mask 120.

The step of removing 15 the portion 124 of the mask 120 may in an optional step comprise removing 15b a first portion 124b of the second layer 120b of the mask 120.

The first portion 124b of the second layer 120b of the mask 120 is a portion above the first portion 124a of the first layer 120a of the mask 120.

The step of removing 15a the first portion 124a of the first layer 120a of the mask 120 and the step of removing 15b a first portion 124b of the second layer 120b of the mask 120 may be performed in any order with regard to each other.

A width 115a of the removed first portion 124a of the first layer 120a may differ from a width 115b of the removed first portion 124b of the second layer 120b.

In some embodiments, as exemplified in Fig. 3c, the width 115b of the removed first portion 124b of the second layer 120b of the mask 120 may be larger than the width 115a of the removed first portion 124a of the first layer 120a of the mask 120.

In some embodiments, the step of removing 15a the first portion 124a of the first layer 120a of the mask 120 may be performed in a first etch process, and removing 15b the first portion 124b of the second layer 120b of the mask 120 may be performed in a second etch process. The second etch process may be subsequent to the first etch process.

Referring to Fig. 4, the method 10 may in an optional step comprise conformally coating 20 the semiconductor fin 110 with a gate oxide layer 160. In a case where a gate is formed to straddle the semiconductor fin 110, the gate oxide 160 is arranged between the semiconductor fin 110 and the gate, thus the gate oxide 160 may electrically insulate the semiconductor fin 110 from the gate. The gate oxide layer 160 may have a thickness of at least 10 nm, preferably at least 20 nm, more preferably at least 40 nm.

The method 10 may in an additional optional step comprise removing 18 oxide formed during the step of oxidizing the exposed portion 114 of the top surface 113 and the first side surface 111 and/or the second side surface 112. The step of removing 18 said oxide is performed before the step of conformally coating 20 the semiconductor fin 110 with the gate oxide layer 160.

The method 10 may in an optional step comprise forming 22 a 3D-NAND memory system on the substrate 102.

The method 10 may in an additional optional step comprise forming 24 a wordline transistor on the substrate 102, wherein a channel region of the wordline transistor comprises the semiconductor fin 110.

In some embodiments the method 10 comprises:
Depositing the first layer 120a of the mask 120 comprising SiO and the second layer 120b of the mask 120 comprising SiN on top of the substrate 102, the substrate 102 comprising Si.

Etching out the semiconductor fin 110 from the substrate 102 by using the mask 120 as an etch mask such that the mask 120 remains covering the top surface 113 of the semiconductor fin 110.

Exposing 14 the portion 114 of the top surface 113 of the semiconductor fin by laterally etching the mask 120, with an etch comprising HF and H₃PO₄, forming the exposed top corner 130 of the semiconductor fin 110, a portion of the mask 130 remaining on the top surface 113 of the semiconductor fin 110.

Rounding 16 the exposed top corner 130 by oxidizing 17 Si of the semiconductor fin via wet-oxidation to form SiO. The height 117 of the semiconductor fin 110 may be unchanged by the rounding 16 of the exposed top corner 130.

Depositing, via flowable chemical vapor deposition (FCVD), a layer of SiO, referred to as STI oxide, the STI oxide covering the semiconductor fin 110, the mask 120, and at least parts of the semiconductor structure 100. Planarizing the semiconductor structure 110, via chemical mechanical polishing (CMP), until exposing a top surface of the second layer 120b of the mask 120.

Recessing the STI oxide by etching with HF, thus revealing the second layer 120b of the mask 120, and removing the second layer 120b of the mask 120 completely.

Further recessing the STI oxide, including the SiO formed during the wet-oxidation and the first layer 120a of the mask 120, in order to reveal a desired height of the semiconductor fin 110.

The embodiment outlined above should not be perceived as limiting the scope of the invention, but merely to serve as an example of how the method may be carried out.

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. A method for producing a semiconductor structure (100), the method comprising:
providing (12) a semiconductor fin (110) on a substrate (102), the semiconductor fin (110) comprising a first side surface (111), a second side surface (112) opposing the first side surface (111), and a top surface (113), wherein a mask (120) covers the top surface (113) of the semiconductor fin (110);
exposing (14) a portion (114) of the top surface (113) of the semiconductor fin (110) by removing (15) a portion (124) of the mask (120), the exposed portion (114) of the top surface (113) and the first side surface (111) forming an exposed top corner (130) of the semiconductor fin (110);
rounding (16) the exposed top corner (130) of the semiconductor fin (110) by oxidizing (17) the exposed portion (114) of the top surface (113) and the first side surface (111).

2. The method according to claim 1, wherein a width (115) of the exposed portion (114) of the top surface (113) of the semiconductor (110) fin is at least 5% of a width (116) of the fin.

3. The method according to any one of the previous claims, wherein removing (15) the portion (124) of the mask (120) comprises laterally etching at least part of the mask (120).

4. The method according to claim 3, wherein laterally etching the mask (120) comprises wet etching.

5. The method according to any of the previous claims, wherein the mask (120) comprises a first layer (120a) and a second layer (120b), the first layer (120a) being arranged between the top surface (113) of the semiconductor fin (110) and the second layer (120b),
wherein removing (15) the portion (124) of the mask (120) comprises
removing (15a) a first portion (124a) of the first layer (120a) of the mask (120); and
removing (15b) a first portion (124b) of the second layer (120b) of the mask (120);
wherein the first portion (124b) of the second layer (120b) of the mask (120) is a portion above the first portion (124a) of the first layer (120a) of the mask (120).

6. The method according to claim 5, wherein a width (115b) of the removed first portion (124b) of the second layer (120b) of the mask (120) is larger than a width (115a) of the removed first portion (124a) of the first layer (120a) of the mask (120).

7. The method according to claim 5 or 6, wherein
removing (15a) the first portion (124a) of the first layer (120a) of the mask (120) is performed in a first etch process; and
removing (15b) the first portion (124b) of the second layer (120b) of the mask (120) is performed in a second etch process, the second etch process being subsequent to the first etch process.

8. The method according to any one of the previous claims, wherein oxidizing (17) the exposed portion (114) of the top surface (113) and the first side surface (111) is performed by wet oxidation.

9. The method according to claim 8, wherein the wet oxidation comprises an in-situ steam generation, ISSG, process.

10. The method according to any one of the previous claims, further comprising conformally coating (20) the semiconductor fin (110) with a gate oxide layer (160).

11. The method according to claim 10, the method further comprising removing (18) oxide formed during the step of oxidizing the exposed portion (114) of the top surface (113) and the first side surface (111), wherein removing (18) said oxide is performed before the step of conformally coating (20) the semiconductor fin (110) with the gate oxide layer (160).

12. The method according to claim 10 or 11, wherein the gate oxide layer (160) has a thickness of at least 10 nm.

13. The method according to any one of the previous claims, wherein a length of the fin is at least 100 nm.

14. The method according to any of the previous claims, wherein the semiconductor fin (110) comprises silicon.

15. The method according to any of the previous claims, further comprising:
forming (22) a 3D-NAND memory system on the substrate (102); and
forming (24) a wordline transistor on the substrate (102), wherein a channel region of the wordline transistor comprises the semiconductor fin (110).
